Europäisches Patentamt

**European Patent Office**

Office européen des brevets

(19)

(11) Veröffentlichungsnummer: **0 010 151**
**B1**

(12) **EUROPÄISCHE PATENTSCHRIFT**

(45) Veröffentlichungstag der Patentschrift:
**29.04.81**

(21) Anmeldenummer: **79103302.0**

(22) Anmeldetag: **05.09.79**

(51) Int. Cl.³: **G 01 R 19/165**, B 60 L 1/12,
G 01 R 15/04

(54) Schaltung zur Unterscheidung von hohen Gleich- oder Wechselspannungen.

(30) Priorität: **02.10.78 DE 2842965**

(43) Veröffentlichungstag der Anmeldung
**30.04.80 Patentblatt 80/9**

(45) Bekanntmachung des Hinweises auf die Patenterteilung:
**29.04.81 Patentblatt 81/17**

(84) Benannte Vertragsstaaten:
**AT BE CH FR IT**

(56) Entgegenhaltungen:
**DE-A-2 116 783**
**DE-A1-2 348 970**
**DE-A1-2 706 130**
**FR-A-1 393 246**

(73) Patentinhaber: **Schaltbau Gesellschaft mbH,**
**Hohenwaldeckstrasse 1, D-8000 München 90 (DE)**

(72) Erfinder: **Baumann, Josef, Robert-Koch-Strasse 24,**
**D-8025 Unterhaching (DE)**
Erfinder: **Meissl, Robert, Spechtstrasse 17,**
**D-8031 Eichenau (DE)**

(74) Vertreter: **Schneider, Wilhelm,**
**Kabelkamp 20 Postfach 260, D-3000 Hannover 1 (DE)**

BUNDESDRUCKEREI BERLIN

Schaltung zur Unterscheidung von hohen Gleich- oder Wechselspannungen

Die Erfindung bezieht sich auf eine Schaltung, die es ermöglicht, unter galvanischer Trennung der Auswerte-Einrichtung mittels eines Photokopplers hohe Gleich- oder Wechselspannungen nach Spannungshöhe und/oder Stromart zu unterscheiden.

Es sind elektrische Einrichtungen bekannt, die betriebsmäßig dazu bestimmt sind, an Spannungen unterschiedlicher Höhe und/oder Stromart betrieben zu werden. Dies erfordert bei der Verwendung ohmscher oder induktiver Lasten die anstehende Spannung nach Höhe und Stromart zu unterscheiden. So werden z. B. im grenzüberschreitenden Verkehr eingesetzte Reisezugwagen über die sogenannte Zugsammelschiene mit elektrischer Energie versorgt, wobei Spannung und Stromart von Land zu Land verschieden sein können. Damit die einzelnen Verbraucher eines Wagens die richtige Spannung erhalten, werden sie mit Hilfe einer Umschalteinrichtung in entsprechende Gruppen aufgeteilt, so daß unter anderem bei hoher Betriebsspannung alle Verbraucher eines Stromkreises in Serie, bei niedriger Spannung dagegen alle parallel geschaltet sind. Bei induktiven Verbrauchern sind außerdem noch zusätzliche Schaltmaßnahmen in Abhängigkeit von der Stromart vorzunehmen, z. B. Einschalten eines Gleichrichters oder eines Transformators. Damit die Umschalteinrichtung die gewünschte Schaltung einnimmt, erhält sie aus der Mehrspannungswähleinrichtung ein entsprechendes Signal.

Eine Mehrspannungswähleinrichtung hat die Aufgabe, die an der Zugsammelschiene anstehende Spannung nach Höhe und Stromart zu erfassen und ein daraus abgeleitetes Signal an die Umschalteinrichtung weiterzuleiten. Eine solche Mehrspannungswähleinrichtung ist aus der DE-OS 25 01 338 bekannt, bei der eine Teilspannung, sowohl zwei Schwingkreisen mit den üblichen Frequenzen der Betriebswechselspannung, als auch einem RC-Glied zugeführt werden. Über nachgeschaltete Trigger-Stufen werden Relais geschaltet, die ihrerseits die Umschalteinrichtung nach der anstehenden Spannung schalten. Die galvanische Trennung verläuft bei dieser Wähleinrichtung erst auf der Höhe der letztgenannten Relais, so daß deren Erregerspulen und sämtliche davor liegende Bauelemente auf hohem Potential liegen. Da für die Spulenerregung und andere hochspannungsseitige, elektrische und elektronische Bauelemente eine Hilfsspannung erforderlich ist, haben solche Wähleinrichtungen den Nachteil, daß ein verhältnismäßig teurer Gleichspannungswandler vorgesehen werden muß, der die Hilfsstromkreise aus der Wagenbatterie speist und der so beschaffen sein muß, daß eine galvanische Trennung zwischen Wagenbatterie und dem Hochspannungsteil der Wähleinrichtung vorhanden ist.

Der vorliegenden Erfindung liegt die Aufgabe zugrunde, zur Ermittlung von Höhe und Stromart der anzustehenden Spannung eine Schaltung anzugeben, bei der hochspannungsseitig auf Hilfsspannungen verzichtet werden kann und möglichst wenige Bauteile vorhanden sind, und bei der Bauteile mit mechanischer Funktion, wie z. B. Relais, niederspannungsseitig angeordnet sind.

Gegenstand der vorliegenden Erfindung ist eine Schaltung zur Unterscheidung von hohen Gleich- oder Wechselspannungen verschiedener Höhe unter galvanischer Trennung der Auswerte-Einrichtung von der Hochspannung mittels eines Photokopplers, die sich von den bisher bekannten dadurch unterscheidet, daß die Spannung an einem Spannungsteiler liegt, dessen erdnächstes Glied eine Zenerdiode ist, der in Richtung gegen die anstehende Spannung ein ohmscher Widerstand, eine gegen die Zenerdiode gerichtete Diode, sowie ein oder mehrere weitere ohmsche Widerstände folgen, wobei parallel zur Zenerdiode und dem nächstfolgenden ohmschen Widerstand ein Kondensator geschaltet ist und aus dem Spannungsteiler mit einer höheren Spannung als der Zenerspannung über eine Diode ein Kondensator gegen Erde aufgeladen wird, zu dem eine Reihenschaltung aus einer Thyristor-Tetrode, einem Entladewiderstand und die Leuchtdiode eines Photokopplers parallel liegt, wobei das Anodengitter der Thyristor-Tetrode über einen Vorwiderstand an der Zenerspannung liegt und der Phototransistor des Photokopplers eine von den Entladungen des Kondensators abhängige Impulsfolge für die Auswerte-Einrichtung schaltet.

Der besondere Vorteil der erfindungsgemäßen Schaltung ist in Erfüllung der gestellten Aufgabe darin zu sehen, daß hochspannungsseitig keine Bauteile vorhanden sind, die einer Hilfsspannung bedürfen und die einem mechanischen Verschleiß unterliegen.

Die erfindungsgemäße Schaltung eignet sich besonders zur Verwendung in Mehrspannungswähleinrichtungen zur Ermittlung der Höhe der anstehenden Spannung und somit zur Betätigung von Gruppierungsschaltungen für elektrische Zugbeheizungen.

Darüber hinaus kann die erfindungsgemäße Schaltung auch zur Prüfung der an einem einzelnen Heizelement anstehenden Spannung verwendet werden, wie dies zur Überprüfung der richtigen Gruppierung der Heizelemente üblich ist. In Weiterbildung der Erfindung kann dabei sowohl zur Ermittlung der für die Zugbeheizung anstehenden Spannung, als auch zur Prüfung der an einem Heizelement anstehenden Spannung ein und dieselbe Zenerspannung benutzt werden.

Die Figuren zeigen in zum Beispiel schematischer Darstellung ein Ausführungsbeispiel einer Schaltung nach der Erfindung.

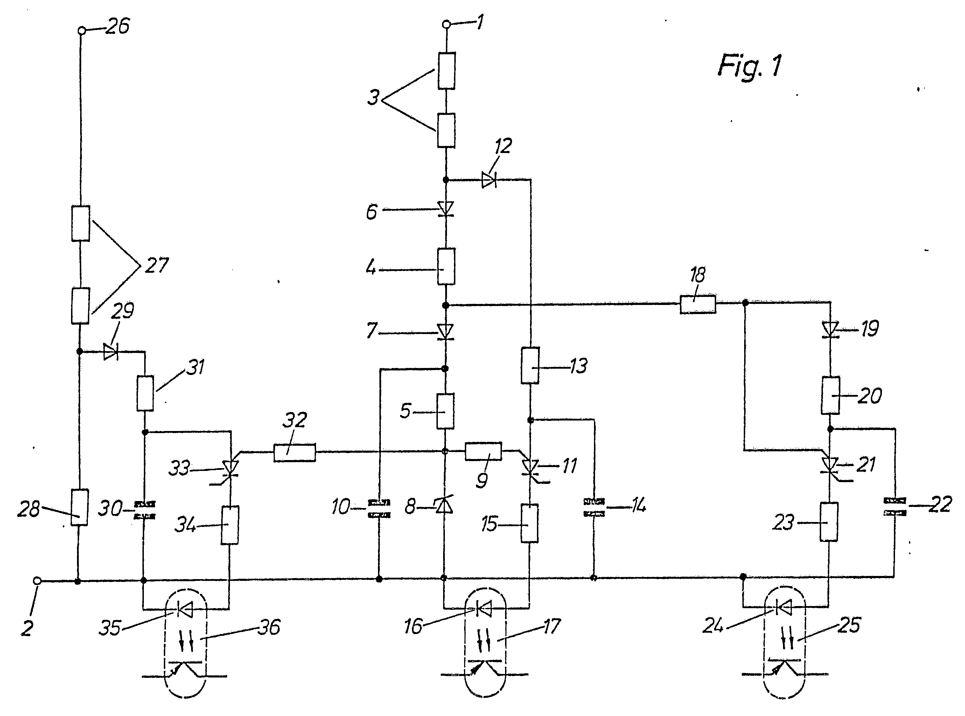

Die Schaltung nach Figur 1 dient dazu, die bei 1 gegen die Erde 2 anstehende Spannung zu ermitteln, wobei die Erde 2 (im Zugbetrieb die Wagenerde) bei Anstehen von Gleichstrom stets an Minus liegt. Über die Widerstände 3, 4 und 5 und die Dioden 6 und 7 wird an der Zenerdiode 8 eine stabile Spannung erzeugt und über den Widerstand 9 dem Anodengitter der Thyristor-Tetrode 11 zugeleitet. Bei Anstehen von Wechselspannungen dient der Kondensator 10 der Versorgung der Zenerdiode 8 während der negativen Halbwelle. Mit der zwischen den Widerständen 3 und der Diode 6 liegenden Teilspannung wird über die Diode 12 und den Widerstand 13 der Kondensator 14 aufgeladen. Die gleiche Spannung wie am Kondensator 14 steht auch an der Anode der Thyristor-Tetrode 11 an. Hat die Spannung am Kondensator 14 und an der Anode einen Wert erreicht, der etwa 0,6 Volt über der Zenerspannung von 8 liegt, dann zündet die Thyristor-Tetrode 11. Der Kondensator 14 wird stoßartig über 11, Widerstand 15 und Leuchtdiode 16 des Photokopplers 17 entladen, dessen Phototransistor einen von der Entladung des Kondensators 14 abhängigen Impuls für die Nachfolge-Auswerte-Einrichtung schaltet. Dieser Vorgang wiederholt sich ständig, wobei der zeitliche Abstand zwischen den Impulsen ein Maß für die Spannung zwischen 1 und 2 ist. Wegen der Mehrfachbelastung der Spannungsteilerkette 3 bis 8 und den darin enthaltenden nicht linearen Bauteilen besteht jedoch zwischen der Spannung und dem Abstand der Impulse kein linearer Zusammenhang.

Weiterhin ist in Figur 1 dargestellt, wie nach dem gleichen Prinzip die an einem Verbraucher anstehende Spannung, z. B. zur Prüfung der Gruppierung von Heizelementen die an einem Heizelement anstehende Spannung überprüft werden kann. Die zu prüfende Spannung steht zwischen 26 und Erde 2 an. Die Widerstände 27 und 28 bilden einen Spannungsteiler. Die an 28 entstehende Teilspannung wird über die Diode 29 und dem Vorwiderstand 31 zur Aufladung des Kondensators 30 gegen Erde 2 benutzt. Gleichzeitig steht diese Spannung auch an der Anode der Thyristor-Tetrode 33, deren Anodengitter über den Widerstand 32 auf der Zenerspannung von 8 liegt. Überschreitet die am Kondensator 30 und der Anode der Thyristor-Tetrode 33 anstehende Spannung die Zenerspannung, so tritt auch hier eine Entladung des Kondensators 30 über 33, den Entladewiderstand 34 und die Leuchtdiode 35 des Photokopplers 36 ein. Auch hier ist der zeitliche Abstand zwischen den Impulsen ein Maß für die zwischen 26 und Erde 2 anstehende Spannung. Überschreitet diese einen vorgegebenen Wert, so kann mit Hilfe einer vom Phototransistor des Photokopplers 36 angesteuerten Auswerteschaltung ein Abschalten der gesamten Einrichtung bewirkt werden.

In Weiterbildung der Erfindung wird zur Ermittlung von Stromart und Frequenz der anstehenden Spannung an einem nur von der positiven Halbwelle durchflossenen Teil des Spannungsteilers eine Spannung abgegriffen, die sowohl über eine Diode und einen Widerstand gegen Erde einen Kondensator auflädt als auch dem Anodengitter einer Thyristor-Tetrode zugeführt wird, die mit einem Entladewiderstand und der Leuchtdiode eines Photokopplers in Reihe parallel zu dem Kondensator geschaltet ist. Der Phototransistor der Photodiode schaltet dann eine von den Entladungen des Kondensators abhängige Impulsfolge für die Auswerte-Einrichtung.

Die Schaltung zur Erfassung von Stromart und Frequenz ist ebenfalls in Figur 1 einbezogen. Zwischen dem Widerstand 4 und der Diode 7 wird eine Spannung abgegriffen, die stets nur die positive Halbwelle einer bei 1 anstehenden Wechselspannung erfaßt und über einen Vorwiderstand 18 ihrerseits über die Diode 19 und den Widerstand 20 den Kondensator 22 auflädt und zum anderen an das Anodengitter der Thyristor-Tetrode 21 gelegt ist. Die Reihenschaltung aus Thyristor-Tetrode 21, Widerstand 23 und Leuchtdiode 24 des Photokopplers 25 liegt parallel zum Kondensator 22. Beim Abfall der positiven Halbwelle wird das Anodengitter der Thyristor-Tetrode 21 gegenüber der Anode kurz von dem Null-Durchgang negativ und leitet die Zündung ein. Der Kondensator 22 wird bei jedem von Plus nach Minus gehenden Polaritätswechsel über 21, 23 und 24 entladen. Der zeitliche Abstand der von dem Phototransistor des Photokopplers 25 geschalteten Gleichstromimpulse ist ein Maß für die Frequenz der bei 1 anstehenden Spannung. Steht bei 1 Gleichspannung an, so bleibt der Photokoppler 25 unbetätigt. Die Diode 6 im Spannungsteiler dient als Schutz für das Anodengitter der Thyristor-Tetrode 21.

Zur Umgruppierung von elektrischen Energieverbrauchern in Reisezugwagen nach Höhe und Frequenz der anstehenden Spannung wird erfindungsgemäß die von dem Photokoppler abgegebene Impulsfolge in Wandlern in Gleichspannungen umgewandelt, die der Spannung und der Frequenz der anstehenden Spannung entsprechen. Diese Gleichspannungen werden über Schmitt-Trigger mit unterschiedlichen Schwellwerten einer Logigschaltung zugeführt, die ihrerseits über Relais die Umschalteinrichtung betätigt.

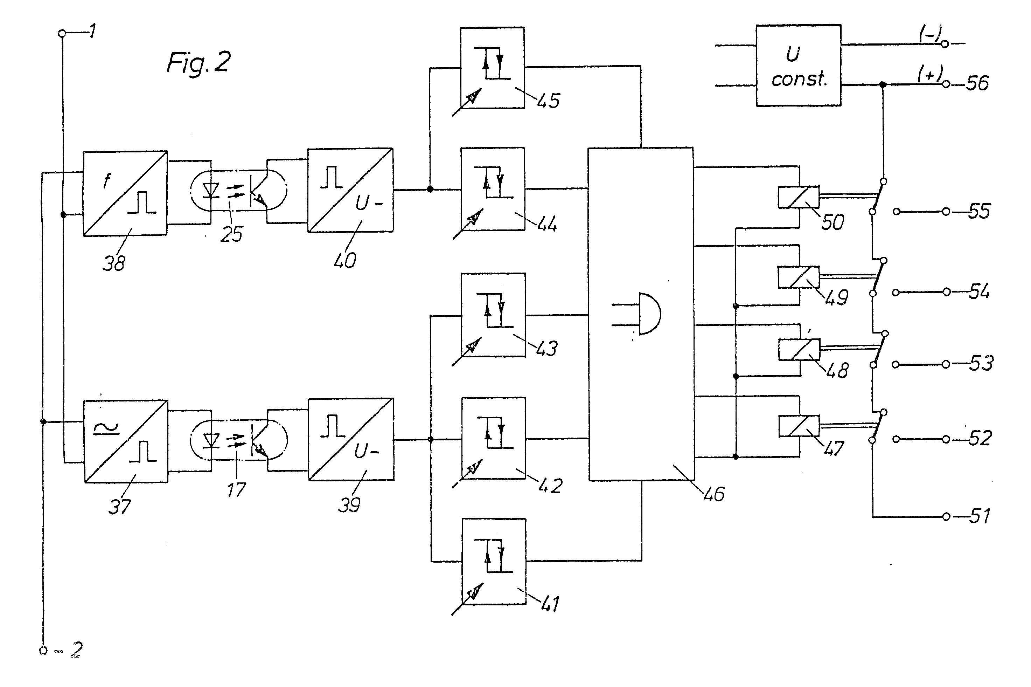

Eine solche Schaltung ist in Figur 2 dargestellt. Die Wandler 37 und 38 entsprechen dabei der Schaltung der Bauelemente 6 bis 16 bzw. 19 bis 24 der Figur 1. Die über die Photokoppler 25 und 17 geleiteten Impulsfolgen werden an den Wandlern 39 und 40 in Gleichspannungen umgesetzt und zwei Gruppen von Schmitt-Trigger zugeführt. Die Schmitt-Trigger 41, 42 und 43 haben unterschiedlich hohe Schwellwerte, so daß stets die ansprechen, deren Schwellwerte niedriger sind als die zwischen 1 und 2 anstehende Spannung und entsprechende Signale in die Logigschaltung 46 leiten. Entsprechend verhalten sich die Schmitt-Trigger 44 und 45, wenn bei 1 und 2 eine Wechselspannung ansteht. Die Höhe der in dem Wandler 40 erzeugten Gleichspannung bringt dann einen oder beide Trigger 43 und 44 zum Ansprechen. In der Logigschaltung 46 werden die aus den Schmitt-Triggern genommenen Signale ausgewertet und jeweils eines der Relais 47 bis 50 betätigt, deren Kontakte über die Anschlüsse 51 bis 55 den bei 56 anstehenden Plus der Wagenbatterie zur Umschalteinrichtung schalten.

Der besondere Vorteil der in Figur 2 angegebenen Schaltung ist, daß hochspannungsseitige Energie sparend gearbeitet wird. Darüber hinaus ist der Aufbau niederspannungsseitig einfach, da die in Figur 2 dargestellten elektrischen Komponenten größtenteils als IC's auf dem Markt sind. Schließlich bringt die Verwendung von Photokopplern eine hohe Spannungsfestigkeit zwischen Hoch- und Niederspannung zustande.

An die Stelle der Photokoppler können auch Impulstransformatoren gesetzt werden und die Thyristor-Tetroden können durch programmierbare Unijunktion-Transistoren ersetzt werden.

## Patentansprüche

1. Schaltung zur Unterscheidung von hohen Gleich- oder Wechselspannungen verschiedener Höhe unter galvanischer Trennung der Auswerte-Einrichtung von der Hochspannung mittels eines Photokopplers, dadurch gekennzeichnet, daß
die Spannung an einem Spannungsteiler liegt, dessen erdnächstes Glied eine Zenerdiode (8) ist, der in Richtung gegen die anstehende Spannung ein ohmscher Widerstand (5), eine gegen die Zenerdiode gerichtete Diode (7), sowie ein oder mehrere weitere ohmsche Widerstände (3, 4) folgen,
wobei parallel zur Zenerdiode (8) und dem nächstfolgenden ohmschen Widerstand (5) ein Kondensator (10) geschaltet ist und
aus dem Spannungsteiler mit einer höheren Spannung als der Zenerspannung über eine Diode (12) ein Kondensator (14) gegen Erde (2) aufgeladen wird, zu dem eine Reihenschaltung aus Thyristor-Tetrode (11), Entladewiderstand (15) und Leuchtdiode (16) eines Photokopplers (17) parallel liegt,
wobei das Anodengitter der Thyristor-Tetrode (11) über einen Vorwiderstand (9) an der Zenerspannung liegt und der Phototransistor des Photokopplers (17) eine von den Entladungen des Kondensators (14) abhängige Impulsfolge für die Auswerte-Einrichtung schaltet.

2. Schaltung nach Anspruch 1, gekennzeichnet durch ihre Verwendung in Mehrspannungswähleinrichtungen zur Ermittlung der Höhe der anstehenden Spannung.

3. Schaltung nach Anspruch 2, gekennzeichnet durch ihre Verwendung zur Ermittlung der anstehenden Spannung in Gruppierungsschaltungen für elektrische Zugbeheizung.

4. Schaltung nach Anspruch 3, gekennzeichnet durch ihre Verwendung zur Prüfung der an einem Heizelement anstehenden Spannung.

5. Schaltung nach Anspruch 4, dadurch gekennzeichnet, daß zur Ermittlung der für die Zugbeheizung anstehenden Spannung und zur Prüfung der an einem Heizelement anstehenden Spannung ein und dieselbe Zenerspannung benutzt wird.

6. Schaltung nach Anspruch 2 oder 3 zur Ermittlung von Stromart und Frequenz der anstehenden Spannung, dadurch gekennzeichnet, daß an einem nur von der positiven Halbwelle durchflossenen Teil des Spannungsteilers eine Spannung abgegriffen wird, die sowohl über eine Diode (19) und einen Widerstand (20) gegen Erde (2) einen Kondensator (22) auflädt als auch dem Anodengitter einer Thyristor-Tetrode (21) zugeführt wird, die mit einem Entladewiderstand (23) und der Leuchtdiode (24) eines Photokopplers (25) in Reihe parallel zu dem Kondensator (22) geschaltet ist und daß der Phototransistor des Photokopplers eine von den Entladungen des Kondensators (22) abhängige Impulsfolge für die Auswerte-Einrichtung schaltet.

7. Schaltung nach den Ansprüchen 3 und 6, dadurch gekennzeichnet, daß die von den Photokopplern (17, 25) abgegebenen Impulsfolgen in Wandlern (39, 40) in der Spannung und der Frequenz der anstehenden Spannung entsprechende Gleichspannungen umgewandelt werden, die über Schmitt-Trigger (41—45) mit unterschiedlichen Schwellwerten einer Logigschaltung (46) zugeführt werden, die ihrerseits über Relais (47—50) eine Umschalteinrichtung betätigt.

## Claims

1. A circuit for distinguishing between high direct or alternating voltage of different amplitudes whilst electrically isolating the evaluation device from the high voltage by means of an optocoupler, characterised in that the voltage is applied to a voltage divider the element closest to earth of which is a Zener diode (8) which is followed in the direction of the applied voltage by an ohmic resistance (5), a diode (7) which is connected to oppose the Zener diode, and one or several further ohmic resistances (3, 4), a capacitor (10) being connected in parallel with the Zener diode (8) and the next-following ohmic resistance (5) and that a capacitor (14) is charged with respect to earth (2) via a diode (12) from the voltage divider with a voltage which is higher than the Zener voltage, this capacitor (14) being connected in parallel with a series circuit consisting of the thyristor tetrode (11), the discharge resistance (15) and the light-emitting diode (16) of an opto-coupler (17), and that the anode of the thyristor tetrode (11) is connected via a bias resistance (9) to the Zener voltage and the photo transistor of the opto-coupler (17) switches a pulse sequence, which depends on the discharges of the capacitor (14), for the evaluation divice.

2. A circuit according to Claim 1, characterised in that it is used in multiple-voltage selection devices for determining the amplitude of the voltage applied.

3. A circuit according to Claim 2, characterised in that it is used for determining the voltage applied in grouping circuits for electric train-heating.

4. A circuit according to Claim 3, characterised in that it is used for checking the voltage applied to a heating element. ＼

5. A circuit according to Claim 4, characterised in that one and the same Zener voltage is used for determining the voltage available for the train heating system and for checking the voltage applied to a heating element.

6. A circuit according to Claim 2 or 3 for determining the type of current and frequency of the voltage applied, characterised in that at a part of the voltage divider through which only the positive half-wave passes, a voltage is tapped off which both charges a capacitor (22) with respect to earth (2) via a diode (19) and a resistance (20) and is also fed to the anode of a thyristor tetrode (21) which in series with a discharge resistance (23) and the lightemitting diode (24) of an opto-coupler (25) is connected in parallel with the capacitor (22) and that the porto transistor of the opto-coupler switches a pulse sequence, which depends on the discharges of the capacitor (22), for the evaluation device.

7. A circuit according to Claims 3 and 6, characterised in that the pulse sequences put out by the opto-couplers (17, 25) are converted in converters (39, 40) into direct voltages which correspond to the voltage and the frequency of the voltages applied and which are supplied via Schmitt triggers (41—45) having different threshold values to a logic circuit (46) which, in turn, actuates a switching device via relays (47, 50).

**Revendications**

1. Montage pour distinguer des hautes tensions continues ou alternatives de hauteur différente avec séparation galvanique entre le dispositif d'exploitation et la haute tension au moyen d'un phṵto-coupleur, carractérisé en ce que la tension est appliquée à un diviseur de tension dont le composant le plus rapproché de la terre est une diode Zener (8) suivie dans la direction opposée à la tension appliquée d'une ·résistance ohmique (5), d'une diode (7) dirigée en opposition à la diode Zener, ainsi que d'une ou plusieurs autres résistances ohmiques (3, 4),

— un condensateur (10) étant branché en parallèle à la diode Zener (8) et à la résistance ohmique suivante (5) et

— un condensateur (14) étant chargé par rapport à la terre (2) à partir du diviseur de tension, par l'intermédiaire d'une diode (12), à une tension supérieure à la tension de Zener, le branchement en série d'un thyristor tétrode (11), d'une résistance de décharge (15), et de la diode lumineuse (16) d'un photo-coupleur étant disposé en parallèle au condensateur,

— la grille d'anode du thyristor tétrode (11) étant reliée à la tension de Zener par l'intermédiaire d'une résistance (9), la photo-transistor du photo-coupleur (17) commutant, pour le dispositif d'exploitation, une suite d'impulsions fonction des décharges du condensateur (14).

2. Montage selon la revendication 1, caractérisé par son application à des dispositifs sélecteurs polytension pour déterminer la valeur de la tension appliquée.

3. Montage selon la revendication 2, caractérisé par son application pour déterminer la tension appliquée à des circuits de groupes pour le chauffage électrique des trains.

4. Montage selon la revendication 3, caractérisé par son application pour vérifier la tension appliquée à un élément chauffant.

5. Montage selon la revendication 4, caractérisé en ce qu'on utilise une seule et même tension de Zener pour déterminer la tension fournie pour le chauffage d'un train et pour vérifier la tension appliquée à un élément de chauffage.

6. Montage selon la revendication 2 ou la revendication 3 pour déterminer le type de courant et la fréquence de la tension appliquée, caractérisé en ce que sur une partie du diviseur de tension parcourue uniquement par la demi-onde positive, on prélève une tension chargeant un condensateur (22) par rapport à la terre (2) par l'intermédiaire d'une diode (19) et d'une résistance (20), cette tension étant aussi envoyée à la grille d'anode d'un thyristor tétrode (21) branché, avec en série une résistance de décharge (23) et la diode lumineuse (24) d'un photo-coupleur (25), en parallèle au condensateur (22) et en ce que le photo-transistor du photo-coupleur commute, pour le dispositif d'exploitation, une suite d'impulsions fonction des décharges du condensateur (22).

7. Montage selon les revendications 3 et 6, caractérisé en ce que les suites d'impulsions fournies par les photo-coupleurs (17, 25) sont converties dans des convertisseurs (39, 40) en tensions continues correspondant à la tension et à la fréquence de la tension appliquée, ces tensions étant, par l'intermédiaire de déclencheurs de Schmitt (41 à 45) à valeurs de seuil différentes, envoyées à un circuit logique (46) qui actionne à son tour un dispositif de commutation par l'intermédiaire de relais (47 à 50).

*Fig. 1*

0 010 151

Fig. 2